# EUROPEAN PATENT SPECIFICATION

(11) **EP 3 599 801 B1**
(45) Date of publication and mention of the grant of the patent: **01.05.2024**
(21) Application number: 18185254.2
(22) Date of filing: 24.07.2018
(51) Int. Cl.: H05K 5/00, H01Q 1/32, H01Q 1/12, F16B 5/12

(54) **MOUNTING DEVICE, MOUNTING ARRANGEMENT, AND METHOD FOR MOUNTING**
MONTAGEVORRICHTUNG, MONTAGEANORDNUNG UND VERFAHREN ZUR MONTAGE
DISPOSITIF, AGENCEMENT ET PROCÉDÉ DE MONTAGE

(43) Date of publication of application: 29.01.2020
(73) Proprietor: Continental Automotive Technologies GmbH, 30175 Hannover (DE)
(72) Inventor: Plugaru, Cristian, 93053 Regensburg (DE); Plach, Andreas, 91301 Forchheim (DE)
(74) Representative: Continental Corporation

(56) References cited:
- EP-A1- 2 518 336
- EP-A2- 1 641 069
- DE-A1-102015 104 543
- DE-U1-202017 102 166

## Description

The invention is concerned with an antenna mounting arrangement, and a method for mounting an antenna component.

It is already common knowledge to mount an antenna module on a body in white of a vehicle by means of screws . This mounting method requires a lot of mounting space, which might not be available anywhere in the vehicle.

EP2518336A1 generally concerns mounting components, but not mounting antennas on a vehicle.

EP 2 518 336 A1 and DE 10 2015 104543 A1 concern mounting arrangement of an antenna module on a roof of a vehicle.

It is an object of the present invention to a mounting arrangement of a second component (which is an antenna module) on a first component (which is a body in white of a vehicle) of a vehicle, as well as a method for mounting a second component (which is an antenna module) on a first component (which is a body in white of a vehicle) of a vehicle, in the field of antenna components.

The object is accomplished by the subject matter of the independent claims. Advantageous developments with convenient and non-trivial further embodiments of the invention are specified in the following description, the dependent claims, and the figure.

One aspect of the invention relates to the mounting arrangement of a second component (which is an antenna module) on a first component (which is a body in white of a vehicle) of a vehicle, a component comprising an antenna. In this mounting arrangement the first component (which is a body in white of a vehicle) is mounted on the second component (which is an antenna module) by means of at least one mounting device. The mounting device comprises a handle portion and a fastening portion. Additionally, the mounting device comprises an elongated portion having a longitudinal extension. The elongated portion is connected to and arranged between the fastening portion and the handle portion. The mounting device is translationally movably arranged on the second component (which is an antenna module) and, by means of the handle portion, translationally movable in relation to the second component (which is an antenna module) along the longitudinal extension of the elongated portion between an introducing position for introducing the fastening position into at least one opening of the first component (which is a body in white of a vehicle), and at least one fastening position for mounting the second component (which is an antenna module) on the first component (which is a body in white of a vehicle) such that the fastening portion engages behind wall portions of the first component (which is a body in white of a vehicle), the wall portions bounding the opening at least partially. In other words, the first component (which is a body in white of a vehicle) is arranged abutting on a first side of the second component (which is an antenna module) . The elongated portion of the mounting device is arranged abutting on a second side of the second component (which is an antenna module) , wherein the second side of the second component (which is an antenna module) is opposite to the first side of the second component (which is an antenna module) . The translational movement of the mounting device runs parallel to an extensional plane of the second component (which is an antenna module) of the vehicle. Preferably, the fastening portion comprises a shaft which is being positioned at least partly in corresponding openings of the first component (which is a body in white of a vehicle) and the second component (which is an antenna module) . Additionally the fastening portion comprises a head adjoining the shaft, wherein the head is arranged on a side of the first component (which is a body in white of a vehicle) facing away from the second component (which is an antenna module) . Preferably the handle portion sticks out beyond at least the second component (which is an antenna module) and especially the second component (which is an antenna module) as well as the first component (which is a body in white of a vehicle) . This allows for the handle portion to be handled very easily.

In a further advantageous embodiment of the present invention, one of the components is an antenna module. Preferably, the second component (which is an antenna module) is the antenna module, which is mounted to the first component (which is a body in white of a vehicle) by means of the mounting device. Normally, the antenna module of a vehicle is mounted in a roof area of the vehicle which comprises very little mounting space. The inventive mounting device allows for the antenna module to be mounted on the first component (which is a body in white of a vehicle) with very little mounting space since the mounting device is handled by use of the handle portion, which is positioned laterally offset along the longitudinal direction of the elongated portion of the mounting device compared to a mounting area, in which the first component (which is a body in white of a vehicle) is mounted on the second component (which is an antenna module) by means of the fastening portion.

In another further embodiment of the present invention, one of the components is a component of a body in white of the vehicle. For example the second component (which is an antenna module) is the antenna module and the first component (which is a body in white of a vehicle) is the body in white of the vehicle, which are mounted together by means of the mounting device. Thus, the mounting arrangement offers a very advantageous way to mount the second component (which is an antenna module) on the body in white of the vehicle, especially in areas of the vehicle, where very little mounting space is provided.

A further aspect of the present invention relates to a method for mounting a second component (which is an antenna module) on a first component (which is a body in white of a vehicle) of a vehicle. In this method the first component (which is a body in white of a vehicle) is mounted on the second component (which is an antenna module) by means of at least one mounting device. The mounting device comprises a handle portion and a fastening portion. Additionally the mounting device comprises an elongated portion having a longitudinal extension. The elongated portion is connected to and arranged between the fastening portion and the handle portion. The mounting device is translationally movably arranged on the second component (which is an antenna module) and by means of the handle portion translationally moved in relation to the second component (which is an antenna module) along the longitudinal extension of the elongated portion from an introducing position for introducing the fastening portion into at least one opening of the first component (which is a body in white of a vehicle), to a fastening position for mounting the second component (which is an antenna module) on the first component (which is a body in white of a vehicle) such that the fastening portion engages behind wall portions of the first component (which is a body in white of a vehicle), the wall portions bounding the opening at least partially.

In other words, the mounting device is arranged on the second component (which is an antenna module) , wherein the elongated portion abuts on a surface of the second component (which is an antenna module) . The fastening portion of the mounting device protrudes through the opening of the second component (which is an antenna module) in the introducing position as well as in the fastening position. For mounting the second component (which is an antenna module) on the first component (which is a body in white of a vehicle), the mounting device is arranged in the introducing position relative to the second component (which is an antenna module) . Subsequently the first component (which is a body in white of a vehicle) is arranged on the second component (which is an antenna module) with their surfaces abutting against each other. The first component (which is a body in white of a vehicle) is arranged on the second component (which is an antenna module) in such a way that a corresponding opening of the first component (which is a body in white of a vehicle) is aligning with the opening of the second component (which is an antenna module) , which opening of the second component (which is an antenna module) is protruded by the fastening portion. While the first component (which is a body in white of a vehicle) is arranged on the second component (which is an antenna module) , the fastening portion is protruded through the corresponding opening of the first component (which is a body in white of a vehicle). The fastening portion comprises a shaft as well as a head adjoining the shaft. In a condition in which the first component (which is a body in white of a vehicle) is arranged to abut on the second component (which is an antenna module) and the fastening portion protrudes the corresponding openings of the first component (which is a body in white of a vehicle) and the second component (which is an antenna module) the shaft is at least partly positioned in the corresponding openings and the head is positioned on a side of the first component (which is a body in white of a vehicle) opposite to the elongated portion. To protrude the fastening portion through the corresponding openings, the circumference of the head preferably corresponds with the corresponding openings of the first component (which is a body in white of a vehicle) and the second component (which is an antenna module) . To mount the second component (which is an antenna module) on the first component (which is a body in white of a vehicle) the elongated portion is translationally moved along the surface of the second component (which is an antenna module) by use of the handle. Due to the fact that the elongated portion and the fastening portion are connected, the head is correspondingly moved translationally along the surface of the first component (which is a body in white of a vehicle) . This means that the head is moved relative to the corresponding openings of the first component (which is a body in white of a vehicle) and the second component (which is an antenna module). By the translational movement of the head the head is engaging behind wall portions bounding the opening of the first component (which is a body in white of a vehicle). In this condition the mounting device is positioned in a fastening position relative to the components. In the fastening position the components are placed between the elongated portion and the head. The head and the elongated portion are holding the second component (which is an antenna module) on the first component (which is a body in white of a vehicle) from opposite sides of the components. To release the first component (which is a body in white of a vehicle) from the second component (which is an antenna module) the mounting device is moved translationally along the longitudinal extension of the elongated portion preferably by means of the handle, starting from the fastening position until the introducing position is reached. In the introducing position the first component (which is a body in white of a vehicle) and the second component (which is an antenna module) are released. This method offers a very simple way of mounting a second component (which is an antenna module) on a first component (which is a body in white of a vehicle) in areas with limited installation space, especially in vehicles.

In the following an exemplary implementation of the invention is described. The figures show:

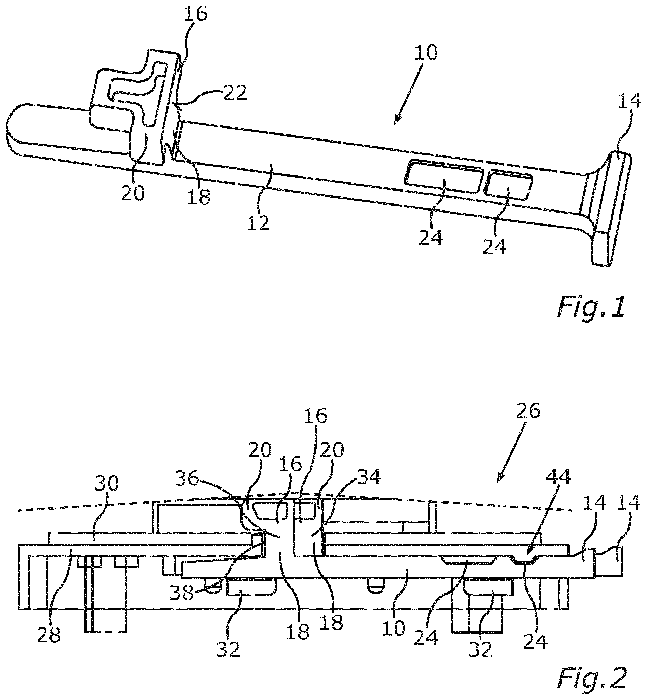

- Fig. 1: a schematic perspective view of a mounting device for mounting a second component (which is an antenna module) on a first component (which is a body in white of a vehicle) of a vehicle with a handle portion, a fastening portion, and an elongated portion;
- Fig. 2: a schematic sectional view of a mounting arrangement of the second component (which is an antenna module) on the first component (which is a body in white of a vehicle) by means of the mounting device in a roof area of a vehicle;

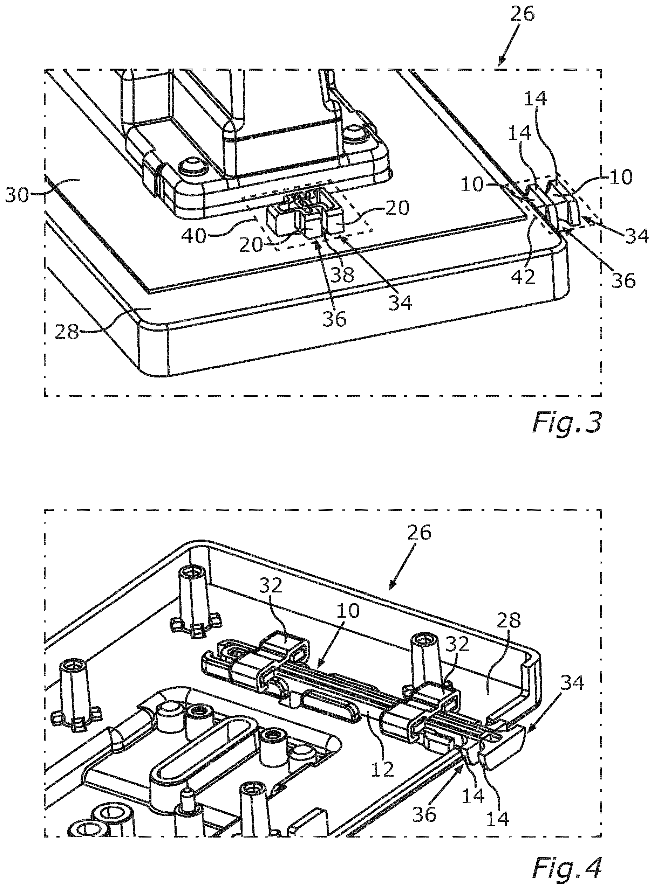

- Fig. 3: a schematic perspective view of the mounting arrangement from above where a head of the fastening portion, which adjoins a shaft of the fastening portion, engages behind wall portions bounding corresponding openings of the second component (which is an antenna module) and the first component (which is a body in white of a vehicle) while the shaft of the fastening portion is at least partially positioned in the corresponding openings;
- Fig. 4: a schematic perspective view of the mounting arrangement from below while the mounting arrangement comprises holding elements, which hold the mounting device abutting against the second component (which is an antenna module) while permitting a translational movement of the mounting device along a surface of the second component (which is an antenna module) and inhibit a movement of the mounting device perpendicular to a longitudinal extension of the elongated portion of the mounting device.

In the figures elements that provide the same function are marked with identical reference signs.

Fig. 1 shows a mounting device 10. By means of the mounting device 10 a first component (which is a body in white of a vehicle) is mountable on a second component (which is an antenna module) of a vehicle preferably in a roof area of the vehicle. The mounting device 10 comprises an elongated portion 12 having a longitudinal extension with a handle portion 14 on one of its ends. Spaced from the handle portion 14 a fastening portion 16 is arranged to protrude from the elongated portion 12. Thus, the elongated portion 12 is connected to and arranged between the fastening portion 16 and the handle portion 14.

As can be seen in Fig. 1, the fastening portion 16 comprises a shaft 18, which is connected to the elongated portion 12 on one of its ends and is connected to a head 20 of the fastening portion 16 on its other end. Therefore, the head 20 is adjoining the shaft 18, wherein the shaft 18 has a first outer circumference and wherein the head 20 has a second outer circumference being greater than the first outer circumference, while these circumferences are measured in reference to the longitudinal extension of the elongated portion 12.

As can also be seen in Fig. 1, the shaft 18 and the head 20 form a T-shaped portion 22. Additionally, the head comprises a T-shaped form, while the head 20 is tapered along a direction extending in parallel to the longitudinal extension direction of the elongated portion 12. The tapering of the head 20 faces away from the handle portion 14. The mounting device 10 is monobloc and therefore the elongated portion 12, the handle portion 14, and the fastening portion 16 are formed in one piece.

The elongated portion 12 comprises two latching elements, which are presently notches 24. Presently the notches 24 are positioned in between the fastening portion 12 and the handle portion 14 facing in the same direction as the protruding fastening portion 16, which extends perpendicularly to the longitudinal extension of the elongated portion 12 from the elongated portion 12. The latching elements are configured to lock the mounting device 10 in various positions relative to at least one of the components, which are to be mounted by means of the mounting device 10. For this purpose the notches 24 are configured to interact with corresponding protrusions of at least one of the components.

In Fig. 2 a mounting arrangement 26 is illustrated, wherein the mounting arrangement 26 comprises the mounting device 10 as well as a first component (which is a body in white of a vehicle) 30 and a second component (which is an antenna module) 28, which is to be mounted to the first component (which is a body in white of a vehicle) 30 by means of the mounting device 10. In this case the first component (which is a body in white of a vehicle) 30 is a body in white of the vehicle, preferably a roof, while the second component (which is an antenna module) 28 is an antenna module, which is to be mounted on the body in white of the vehicle. The mounting arrangement 26 also comprises two holding elements 32 which are configured to position the mounting device 10 on a surface of the second component (which is an antenna module) 28, while permitting a translational movement of the mounting device 10 along the longitudinal extension of the elongated portion 12. Any other movement of the mounting device 10 relative to the second component (which is an antenna module) 28 is permitted by the holding elements 32.

As can be seen in Fig. 2, the mounting device 10 is capable of being arranged in at least two different positions relative to the components. The mounting device 10 is configured to be positioned in an introducing position 34, in which the fastening portion 16 can be introduced in an opening of the first component (which is a body in white of a vehicle) 30 which corresponds to an opening of the second component (which is an antenna module) 28, while the opening of the second component (which is an antenna module) 28 encloses the shaft 18 on the circumference. Preferably the corresponding openings of the first component (which is a body in white of a vehicle) 30 and the second component (which is an antenna module) 28 align in the introducing position 34. The shape of the head 20 corresponds with the corresponding openings of the components and is aligned with the corresponding openings of the components in the introducing position 34.

To mount the second component (which is an antenna module) 28 on the first component (which is a body in white of a vehicle) 30 the mounting device 10 is translationally moved from the introducing position 34 to a fastening position 36 by use of the handle portion 14. Thus to move the mounting device 10 from the introducing position 34 to the fastening position 36 the mounting device 10 is moved along the surface of the second component (which is an antenna module) 28 and therefore relative to both of the components along the longitudinal extension of the elongated portion 12. In the fastening position 36 the head 20 engages behind the wall portions 38 bounding the corresponding openings of the components. In doing so the head 20 abuts on an outer surface of the first component (which is a body in white of a vehicle) 30, which surface is facing away from the second component (which is an antenna module) 28. In the fastening position 36 an overlapping area of the first component (which is a body in white of a vehicle) 30 with the second component (which is an antenna module) 28 is located between the head 20 and the elongated portion 12. In this way the first component (which is a body in white of a vehicle) 30 is fixed to the second component (which is an antenna module) 28 by means of at least the head 20 and the elongated portion 12.

To release the two components the mounting device 10 can be moved from the fastening position 36 to the introducing position 34 by use of the handle portion 14. The second component (which is an antenna module) 28 comprises a protrusion 44, which can engage the notches 24 of the mounting device 10. By the engagement of the protrusion 44 in the corresponding notches 24 the mounting device 10 is capable of being fixed in the introducing position 34 and the fastening position 36. Additionally by snapping into either one of the notches 24 the produced protrusion 44 might give a haptic and/or acoustical feedback regarding a reaching or leaving of the respective positions of the mounting device 10 relative to the second component (which is an antenna module) 28.

In Fig. 3 the mounting arrangement 26 is shown in a perspective view from above. It can be seen that the head 20 is moved relative to a surface of the first component (which is a body in white of a vehicle) 30 by moving the mounting device 10 between the introducing position 34 and the fastening position 36 along the longitudinal extension direction of the elongated portion 12. A mounting area 40, in which the first component (which is a body in white of a vehicle) 30 is fastened to the second component (which is an antenna module) 28 by means of the head 20, is laterally offset along the longitudinal extension direction of the elongated portion 12 to an actuation area 42, in which the mounting device 10 is operated by use of the handle portion 14. Thus extremely little mounting space is needed for mounting the second component (which is an antenna module) 28 on the first component (which is a body in white of a vehicle) 30.

Fig. 4 shows the mounting arrangement 26 in a perspective view from below. In this illustration it can be noticed that the second component (which is an antenna module) 28 and the holding elements 32 provide a guiding for the translational movement of the mounting device 10. It can also be seen that the handle portion 14 protrudes from the second component (which is an antenna module) 28 in the introducing position 34 as well as in the fastening position 36. This guarantees that the mounting device 10 can be operated starting from any position of the mounting device 10 relative to the second component (which is an antenna module) 28.

The mounting device 10 can be used to mount the antenna module as the second component (which is an antenna module) 28 in a place of the vehicle where there is not enough space to insert a tool or to be handled by the operated or it is not possible to spend a lot of time for mounting the antenna module. The mounting device 10 offers a way to mount the antenna module in its car position using one hand to operate the handle portion 14 but saving space from the second component (which is an antenna module) 28 which might be a printed circuit board. The handle portion 14 might be pushed by a finger of an operator from one side of the mounting arrangement 26. The mounting arrangement 26 offers a solution of blocking mounting the antenna module in a roof area of the vehicle from one side of the mounting arrangement 26 while it can be avoided to provide more than the one corresponding opening which can be nearly as small as the head 20 of the mounting device 10 in the printed circuit board. The mounting device facilitates on the one hand mounting of the second component (which is an antenna module) 28 on the first component (which is a body in white of a vehicle) 30, on the other hand it offers a lot of space on the printed circuit board since it is a space-efficient mounting solution and it enables the components to be mounted in a very short time. The notches 24 supply tactile feedback for properly mounting the second component (which is an antenna module) 28 on the first component (which is a body in white of a vehicle) 30. It is possible to use this mounting concept not only to mount antenna modules as second component (which is an antenna module) s 28 but all other mounting devices in a vehicle which are possible.

## Claims

1. A mounting arrangement (26) of an antenna module (28) on a body in white (30) of a vehicle, comprising at least one mounting device (10) for mounting the antenna module (28) on the body in white (30) of the vehicle, said at least one mounting device (10) comprising:
- an elongated portion (12) having a longitudinal extension,
- a handle portion (14); and
- a fastening portion (16);
- the elongated portion (12) being connected to and arranged between the fastening (16) and handle (14) portions, wherein the mounting device (10) is translationally movably arranged on the antenna module (28), **characterized in that** by means of the handle portion (14),
the mounting device (10) is translationally movable in relation to the antenna module (28) along the longitudinal extension of the elongated portion (12) between an introducing position (34) for introducing the fastening portion (16) into at least one opening of the body in white (30) of the vehicle, and at least one fastening position (36) for mounting the antenna module (28) on the body in white (30) of the vehicle such that the fastening portion (16) engages behind wall portions (38) of the body in white (30) of the vehicle, the wall portions (38) bounding the opening at least partially.

2. The mounting arrangement (26) according to claim 1,
**characterized in that**
one of the components is a component of a body in white of the vehicle.

3. A method for mounting an antenna module (28) on body in white (30) of a vehicle, in which method the antenna module (28) of the vehicle is mounted on the body in white (30) by means of at least one mounting device (10) which comprises:
- a handle portion (14);
- a fastening portion (16); and
an elongated portion (12) having a longitudinal extension, the elongated portion (12) being connected to and arranged between the fastening (16) and handle (14) portions, wherein the mounting device (10) is translationally movably arranged on the antenna module of the vehicle and, by means of the handle portion (14), translationally moved in relation to the antenna module of the vehicle along the longitudinal extension of the elongated portion (12) from an introducing position (34) for introducing the fastening portion (16) into at least one opening of the body in white (30) of the vehicle, to a fastening position (36) for mounting the antenna module (28) on the body in white (30) of the vehicle such that the fastening portion (16) engages behind wall portions (38) of the body in white (30) of the vehicle, the wall portions (38) bounding the opening at least partially.

## Patentansprüche

1. Montageanordnung (26) eines Antennenmoduls (28) auf einer Rohbaukarosserie (30) eines Fahrzeugs, die mindestens eine Montagevorrichtung (10) zum Montieren des Antennenmoduls (28) auf der Rohbaukarosserie (30) des Fahrzeugs aufweist, wobei die mindestens eine Montagevorrichtung (10) Folgendes aufweist:
- einen lang gestreckten Abschnitt (12) mit einer Längserstreckung;
- einen Griffabschnitt (14); und
- einen Befestigungsabschnitt (16);
- wobei der lang gestreckte Abschnitt (12) mit dem Befestigungsabschnitt (16) und dem Griffabschnitt (14) verbunden und zwischen diesen Abschnitten angeordnet ist, wobei die Montagevorrichtung (10) auf dem Antennenmodul (28) translatorisch bewegbar angeordnet ist, **dadurch gekennzeichnet, dass** mittels des Griffabschnitts (14)
die Montagevorrichtung (10) in Bezug auf das Antennenmodul (28) entlang der Längserstreckung des lang gestreckten Abschnitts (12) zwischen einer Einführungsposition (34) zum Einführen des Befestigungsabschnitts (16) in mindestens eine Öffnung der Rohbaukarosserie (30) des Fahrzeugs und mindestens einer Befestigungsposition (36) zum Montieren des Antennenmoduls (28) auf der Rohbaukarosserie (30) des Fahrzeugs translatorisch bewegbar ist, sodass der Befestigungsabschnitt (16) hinter Wandabschnitten (38) der Rohbaukarosserie (30) des Fahrzeugs einrastet, wobei die Wandabschnitte (38) die Öffnung zumindest teilweise begrenzen.

2. Montageanordnung (26) nach Anspruch 1,
**dadurch gekennzeichnet, dass**
eines der Bauteile ein Bauteil einer Rohbaukarosserie des Fahrzeugs ist.

3. Verfahren zum Montieren eines Antennenmoduls (28) auf einer Rohbaukarosserie (30) eines Fahrzeugs, wobei das Antennenmodul (28) des Fahrzeugs bei diesem Verfahren auf der Rohbaukarosserie (30) mittels mindestens einer Montagevorrichtung (10) montiert wird, die Folgendes aufweist:
- einen Griffabschnitt (14); und
- einen Befestigungsabschnitt (16); und
- einen lang gestreckten Abschnitt (12) mit einer Längserstreckung, wobei der lang gestreckte Abschnitt (12) mit dem Befestigungsabschnitt (16) und dem Griffabschnitt (14) verbunden und zwischen diesen Abschnitten angeordnet ist, wobei die Montagevorrichtung (10) auf dem Antennenmodul des Fahrzeugs translatorisch bewegbar angeordnet ist und mittels des Griffabschnitts (14) in Bezug auf das Antennenmodul des Fahrzeugs entlang der Längserstreckung des lang gestreckten Abschnitts (12) aus einer Einführungsposition (34) zum Einführen des Befestigungsabschnitts (16) in mindestens eine Öffnung der Rohbaukarosserie (30) des Fahrzeugs in eine Befestigungsposition (36) zum Montieren des Antennenmoduls (28) auf der Rohbaukarosserie (30) des Fahrzeugs, sodass der Befestigungsabschnitt (16) hinter Wandabschnitten (38) der Rohbaukarosserie (30) des Fahrzeugs einrastet, wobei die Wandabschnitte (38) die Öffnung zumindest teilweise begrenzen, translatorisch bewegt wird.

## Revendications

1. Agencement de montage (26) d'un module d'antenne (28) sur une caisse en blanc (30) d'un véhicule, comprenant au moins un dispositif de montage (10) pour monter le module d'antenne (28) sur la caisse en blanc (30) du véhicule, ledit au moins un dispositif de montage (10) comprenant :
- une partie allongée (12) ayant une extension longitudinale,
- une partie de poignée (14) ; et
- une partie de fixation (16) ;
- la partie allongée (12) étant reliée à et agencée entre les parties de fixation (16) et de poignée (14),
dans lequel le dispositif de montage (10) est agencé de manière mobile en translation sur le module d'antenne (28), **caractérisé en ce qu'**au moyen de la partie de poignée (14),
le dispositif de montage (10) est mobile en translation par rapport au module d'antenne (28) le long de l'extension longitudinale de la partie allongée (12) entre une position d'introduction (34) pour introduire la partie de fixation (16) dans au moins une ouverture de la caisse en blanc (30) du véhicule, et au moins une position de fixation (36) pour monter le module d'antenne (28) sur la caisse en blanc (30) du véhicule de telle sorte que la partie de fixation (16) vient en prise derrière des parties de paroi (38) de la caisse en blanc (30) du véhicule, les parties de paroi (38) délimitant l'ouverture au moins partiellement.

2. Agencement de montage (26) selon la revendication 1,
**caractérisé en ce que**
l'un des composants est un composant d'une caisse en blanc du véhicule.

3. Procédé de montage d'un module d'antenne (28) sur une caisse en blanc (30) d'un véhicule, dans lequel le module d'antenne (28) du véhicule est monté sur la caisse en blanc (30) au moyen d'au moins un dispositif de montage (10) qui comprend :
- une partie de poignée (14) ;
- une partie de fixation (16) ; et
une partie allongée (12) ayant une extension longitudinale, la partie allongée (12) étant reliée à et agencée entre les parties de fixation (16) et de poignée (14), dans lequel le dispositif de montage (10) est agencé de manière mobile en translation sur le module d'antenne du véhicule et, au moyen de la partie poignée (14), déplacé en translation par rapport au module d'antenne du véhicule le long de l'extension longitudinale de la partie allongée (12) d'une position d'introduction (34) pour introduire la partie de fixation (16) dans au moins une ouverture de la caisse en blanc (30) du véhicule, à une position de fixation (36) pour monter le module d'antenne (28) sur la caisse en blanc (30) du véhicule de telle sorte que la partie de fixation (16) vient en prise derrière des parties de paroi (38) de la caisse en blanc (30) du véhicule, les parties de paroi (38) délimitant l'ouverture au moins partiellement.
